Europäisches Patentamt

European Patent Office

Office européen des brevets

(19)

(11) Veröffentlichungsnummer : **0 329 988 B1**

(12) # EUROPÄISCHE PATENTSCHRIFT

(45) Veröffentlichungstag der Patentschrift :
**21.06.95 Patentblatt 95/25**

(51) Int. Cl.⁶ : **H03L 3/00, H03B 5/08, H05B 6/10**

(21) Anmeldenummer : **89101768.3**

(22) Anmeldetag : **02.02.89**

(54) **Hochfrequenz-Leistungsgenerator.**

(30) Priorität : **25.02.88 DE 3805921**

(43) Veröffentlichungstag der Anmeldung :
**30.08.89 Patentblatt 89/35**

(45) Bekanntmachung des Hinweises auf die
Patenterteilung :
**21.06.95 Patentblatt 95/25**

(84) Benannte Vertragsstaaten :
**DE FR GB IT**

(56) Entgegenhaltungen :
**EP-A- 0 237 795**
**FR-A- 2 391 588**
**GB-A- 915 393**
**GB-A- 1 128 560**
**US-A- 3 381 533**
**ELEKTRONIK, Heft 4, 25. Februar 1983, Seiten 67-71, München, DE; H. FOCH et al.: "DC/AC-Wandler mit hohem Wirkungsgrad"**
**PATENT ABSTRACTS OF JAPAN, Band 6, Nr. 60 (E-102)[938], 17. April 1982; & JP-A-57 2130**

(73) Patentinhaber : **Lindenmeier, Heinz, Prof. Dr.-Ing.**
**Fürstenriederstrasse 7**
**D-82152 Planegg (DE)**
Patentinhaber : **Flachenecker, Hildegard**
**Bozenerstrasse 2**
**D-85521 Ottobrunn (DE)**

(72) Erfinder : **Flachenecker, Gerhard, Prof. Dr.-Ing.**
**verstorben (DE)**
Erfinder : **Fastenmeier, Karl, Prof. Dr.-Ing.**
**Pasettiweg 2**
**D-8000 München 83 (DE)**
Erfinder : **Lindenmeier, Heinz, Prof. Dr.-Ing.**
**Fürstenrieder Strasse 7**
**D-8033 Planegg (DE)**

(74) Vertreter : **Endlich, Fritz, Dipl.-Phys.**
**Patentanwalt et al**
**Blumenstrasse 14**
**D-82110 Germering (DE)**

**Beschreibung**

Die Erfindung bezieht sich auf einen Hochfrequenz-Leistungsgenerator entsprechend dem Oberbegriff des Anspruchs 1.

Für viele industrielle, medizinische oder wissenschaftliche Anwendungen werden hohe Hochfrequenz-Leistungen benötigt. Beispiele aus dem industriellen Bereich sind Trockeneinrichtungen, die mit der Erwärmung eines Materials durch dielektrische Verluste im Hochfrequenzfeld arbeiten oder Schmelzvorrichtungen, bei denen die Erwärmung eines Schmelzgutes über Wirbelströme in Hochfrequenzfeld erfolgt. In der Medizin werden Hochfrequenzleistungen z.B. für die Hochfrequenzchirurgie benötigt und in der Wissenschaft z.B. für die Anregung eines Plasmas in der Spektralanalyse.

Hochfrequenz-Leistungsgeneratoren sind z.B. aus GB-A-1 128 560 bekannt.

Den meisten Anwendungen ist gemeinsam, daß die Belastung des Hochfrequenz-Leistungsgenerators in der Regel nicht konstant ist, sondern oft sehr großen und raschen Änderungen unterworfen ist. In der Hochfrequenzchirurgie kann sich z.B. die Impedanz einer an den Hochfrequenz-Leistungsgenerator angeschlossenen Chirurgiesonde innerhalb von Millisekunden zwischen etwa 50 Ohm und 4 kOhm ändern. Auch die Blindkomponente der Latimpedanz kann schnell und in größeren Bereichen schwanken. Ein Beispiel hierfür ist der Moment des Schmelzens in einem Hochfrequenz-Schmelzofen: Während das Schmelzgut im Schmelztiegel zunächst lose zusammenliegt, vereinigt es sich im Moment des Schmelzens zu einer großen gemeinsamen Masse. Die Stromverteilung im Schmelzgut und damit die räumliche Verteilung des Magnetfeldes kann sich in diesem Augenblick grundlegend ändern. Für den Hochfrequenz-Leistungsgenerator stellt sich dieser Vorgang als schnelle Änderung des Blindanteils der Latimpedanz dar.

Eine weitere Gemeinsamkeit dieser Anwendungen ist die Tatsache, daß der mit der Hochfrequenzleistung zu erzeugende Effekt nicht auf eine sehr strenge Einhaltung der Frequenz angewiesen ist. In der Hochfrequenzschirurgie sind z.B. Frequenzen zwischen 300 kHz und 2 MHz üblich, ohne daß dabei in der Anwendung spürbare Unterschiede entstehen. Bei Hochfrequenz-Schmelzöfen werden sogar Frequenzen zwischen 200 kHz und 27 MHz angewandt. Eine Einhaltung gewisser Frequenzbereiche kann höchstens durch postalische Vorschriften zur Vermeidung von Störstrahlung vorgeschrieben sein, wenn das vom Hochfrequenz-Leistungsgenerator erzeugte Feld nicht abgeschirmt ist. Bei hinreichend abgeschirmten Anwendungen oder bei den meisten Hochfrequenz-Chirurgiegeräten entfällt diese Einschränkung aber.

Darüber hinaus besteht bei allen beschriebenen Anwendungen die Forderung nach einem hohen Wirkungsgrad. Bei einem im Operationssaal zu betreibenden Hochfrequenz-Chirurgiegerät ist z.B. kein Lüfter zur Kühlung erlaubt, weil mit dem Kühlluftstrom Bakterien aufgewirbelt werden könnten. Bei einer verfügbaren Hochfrequenzleistung von z.B. 400 W ist dann ein Wirkungsgrad des Hochfrequenz-Leistungsgenerators von mindestens 90% notwendig, wenn sich das Gerät nicht unzulässig erwärmen soll.

Um einen hohen Wirkungsgrad zu erreichen ist es heute üblich, die Verstärkerelemente des Hochfrequenz-Leistungsgenerators, vorzugsweise Transistoren, im Schaltbetrieb zu betreiben. Zum Beispiel arbeiten praktisch alle heute verfügbaren Hochfrequenz-Chirurgiegeräte nach diesem Prinzip. Durch den Schaltbetrieb entstehen Oberwellen im Spektrum der Ausgangsspannung, die viele Nachteile mit sich bringen. In der Hochfrequenzchirurgie können die gegenüber der eigentlichen Betriebsfrequenz sehr viel höherfrequenten Oberwellen hohe kapazitive Leckströme erzeugen, die für den Patienten eine Verbrennungsgefahr darstellen. Weiterhin entstehen durch die nicht vermeidbaren Streuelemente der Schaltung starke Überschwinger, die die Betriebssicherheit der Verstärkerelemente durch Überspannungen gefährden.

Es ist auch bekannt, daß bei Schaltverstärkern wegen der Abschaltverzögerung der Verstärkerelemente nicht beliebig hohe Wirkungsgrade erreicht werden.

In dem Aufaztz "DC/AC-Wandler mit hohen Wirkungsgrad", Elektronik 1983, Heft 4, Seite 67, ist daher ein Hochfrequenz-Leistungsgenerator beschrieben, der mit verschiedenen Maßnahmen versucht, die geschilderten Nachteile einfacher Schaltverstärker zu vermeiden.

Dazu wird ein Leistungsgenerator verwendet, dessen Transistoren als Quasi-Komplementärstufe geschaltet sind und die im Schaltbetrieb arbeiten. Am Ausgang dieses Leistungsverstärkers ist ein in Serie geschalteter Serienresonanzkreis angeschlossen, der den Ausgangsstrom zu einem gegen Masse liegenden, also parallel geschalteten Parallelkreis führt. Die Induktivität dieses Parallelkreises dient zur Lastankopplung, im beschriebenen Beispiel zur Erzeugung von Wirbelströmen in einem Heizgut. Die Transistoren des Leistungsverstärkers werden von einem Festfrequenz-Oszillator angesteuert, der auf die Betriebsfrequenz abgestimmt ist. Sowohl der Serienresonanzkreis als auch der Parallelresonanzkreis sind ebenfalls auf diese Betriebsfrequenz abgestimmt. Durch den Serienresonanzkreis wird erreicht, daß der Ausgangsstrom des Leistungsverstärkers nahezu rein sinusförmig verläuft. Der Strom geht dabei nach jeder Halbperiode der Hochfrequenzschwingung durch Null, d.h. genau dann, wenn der Durchlaßzustand jeweils von einem auf den anderen Transistor umgeschaltet wird. Mit dieser Maßnahme werden die Abschaltverluste in den Transistoren besonders klein, weil der Strom im Transistor im Moment des Abschaltens bereits nach Null gegangen war. Abschaltverzögerungen treten dann im Transistor praktisch nicht mehr auf. Man erreicht mit dieser Maßnahme einen viel höheren Wirkungsgrad als mit einfachen, breitbandigen Schaltverstärkern.

Mit dem Parallelresonanzkreis wird die Lastimpedanz bei der Betriebsfrequenz auf einen reellen Wert gebracht, um Phasenverschiebungen zwischen Strom und Spannung sowie Blindströme zu vermeiden.

Logikschaltungen in den Basiskreisen der Transistoren sorgen noch dafür, daß die Einschaltung des jeweiligen Transistors erst dann erfolgt, wenn die Kollektor-Emitterspannung ungefähr auf den Wert der Sättigungsspannung abgefallen ist, d.h. wenn das Umschwingen der Ausgangsspannung aufgrund der Abschaltung des anderen Transistors abgeschlossen ist. Wird durch diese Logik der Einschaltzeitpunkt des einen Transistors gegenüber dem Ausschaltzeitpunkt des anderen Transistors verzögert, so muß der Strom des Serienresonanzkreises trotzdem weiterfließen können. Zu diesem Zweck sind den Transistoren Freilaufdioden parallel geschaltet.

In der Praxis zeigt dieser Hochfrequenz-Leistungsgenerator aber noch entscheidende Nachteile. Bei Lastschwankungen, insbesondere bei Änderungen des Imaginärteils der Lastimpedanz, wird die Resonanzfrequenz des Parallelresonanzkreises gegenüber der Betriebsfrequenz verstimmt. Damit sind die Spannung am Parallelresonanzkreis und der Strom durch den Serienresonanzkreis nicht mehr in Phase. Dies führt dazu, daß der Nulldurchgang des Ausgangsstromes des Leistungsverstärkers nicht mehr mit dem Umschaltzeitpunkt der Transistoransteuerung zusammenfällt. Als Folge davon treten bei den Transistoren lange Einschaltverzögerungen auf, während denen der Ausgangsstrom durch die Freilaufdioden fließen muß. Erfolgt dann die Einschaltung, so ist der vom Transistor zu übernehmende Strom nicht mehr annähernd Null, wie im Idealfall, sondern kann bereits sehr hohe Werte haben. Dies führt zu stark wachsenden Einschaltverlusten und zu einer drastischen Abnahme des Wirkungsgrades. Durch die Phasenverschiebung reduziert sich grundsätzlich auch die verfügbare Ausgangsleistung des Hochfrequenz-Leistungsgenerators.

Der gleiche Effekt tritt auf, wenn die Resonanzfrequenzen des Serienresonanzkreises oder des Parallelresonanzkreises nicht exakt abgeglichen sind oder sich durch Alterung der Bauelemente die Induktivitäten und Kapazitäten der Resonanzkreise ändern, wobei sich die Resonanzfrequenzen dieser Kreise ebenfalls ändern. Gleiches gilt auch für eine ungenau abgeglichene oder durch Alterung veränderte Betriebsfrequenz des Steueroszillators. In jedem Fall steigen die Verluste in den Transistoren und den Freilaufdioden an, die verfügbare Leistung und der Wirkungsgrad sinken. Bei stärkeren Verstimmungen kann die steigende Verlustleistung bis zur Zerstörung der Verstärkerelemente führen.

Der Erfindung liegt daher Aufgabe zugrunde, einen Hochfrequenz-Leistungsgenerator zu schaffen, dessen Wirkungsgrad und Ausgangsleistung bei starken Änderungen der Lastimpedanz und bei unterschiedlichen Resonanzfrequenzen der Schwingkreise gleichbleibend hoch sind, wodurch außerdem eine Gefährdung des Hochfrequenz-Leistungsgenerators durch Fehlabgleich, Alterung der Bauelemente und starke Lastschwankungen ausgeschlossen und daher ein sicherer Betrieb gewährleistet ist.

Diese Aufgabe wird erfindungsgemäß mit den in den Kennzeichen des Anspruchs 1 und der Unteransprüche vorgeschlagenen Maßnahmen gelöst.

Die Erfindung sieht einen Hilfsoszillator vor, der im Moment der Inbetriebnahme des Hochfrequenz-Leistungsgenerators an den Eingang des Leistungsverstärkers geschaltet ist und dem Hochfrequenz-Leistungsgenerator eine Anschwinghilfe bietet. Im ersten Moment der Inbetriebnahme ist der Hochfrequenz-Leistungsgenerator daher fremdgesteuert. Sobald der Hochfrequenz-Leistungsgenerator jedoch angeschwungen ist, d.h. wenn im Ausgangskreis des Leistungsverstärkers entweder ein von Null deutlich unterschiedlicher Strom fließt oder eine von Null deutlich unterschiedliche Spannung herrscht, wird die Ansteuerung des Leistungsverstärkers auf Selbsterregung, d.h. Rückkopplung aus dem Ausgangskreis des Leistungsverstärkers umgeschaltet. Die Rückkopplungsspannung wird dabei auf zweierlei Art aus dem Ausgangskreis des Leistungsverstärkers entnommen: Sie wird entweder über ein Wandlerglied und Impulsformerstufen aus dem den Serienresonanzkreis durchfließenden Strom gewonnen, wodurch Stromrückkopplung entsteht, oder über ein Wandlerglied und Impulsformerstufen aus der am Parallelresonanzkreis anliegenden Spannung, wodurch Spannungsrückkopplung entsteht.

Für die Umschaltung zwischen Strom- und Spannungsrückkopplung ist ein elektronischer Schalter vorgesehen, der auf Stromrückkopplung schaltet, wenn der Betrag der an den Hochfrequenz-Leistungsgenerator angeschlossenen Lastimpedanz einen charakteristischen, voreingestellten Wert unterschreitet und auf Spannungsrückkopplung, wenn der Betrag der an den Hochfrequenz-Leistungsgenerator angeschlossenen Lastimpedanz einen charakteristischen, voreingestellten Wert überschreitet. Der elektronische Schalter nimmt auch im weiteren Betrieb eine laufende Umschaltung zwischen Strom- und Spannungsrückkopplung vor, wenn die Lastimpedanz schwankt und der Betrag der Lastimpedanz den charakteristischen, voreingestellten Wert über- oder unterschreitet.

Der Hochfrequenz-Leistungsgenerator nach der Erfindung arbeitet nur im Moment des Anschwingens mit einer Fremderregung durch einen Hilfsoszillator. Der eigentliche Betrieb findet aber im Selbsterregungsmode statt. Dabei werden Abweichungen im Frequenzabgleich des Serienresonanzkreises und des Parallelresonanzkreises automatisch durch die notwendige Erfüllung der Rückkopplungsbedingung ausgeglichen. Auch Änderungen im Realteil und insbesondere im Imaginärteil der Lastimpedanz werden durch die Rückkopplung automatisch berücksichtigt. Die Frequenz stellt sich immer so ein, daß die Rückkopplungsbedingung erfüllt ist. Dies ist in der Regel die sich ergebende resultierende Mittenfrequenz der Ausgangsfilters inklusive Lastimpedanz. Frequenzfehler einer Fremdansteuerung können dabei a priori nicht auftreten.

Die Rückkopplungsart ist bei einem Hochfrequenz-Leistungsgenerator nach der Erfindung aber nicht fest gewählt. Es wird vielmehr, je nach Größe der angeschlossenen Lastimpedanz, entweder Stromrückkopplung oder Spannungsrückkopplung gewählt. Bei niederohmigen Lastimpedanzen wird Stromrückkopplung verwendet. Durch die niederohmige Lastimpedanzen ist der Parallelresonanzkreis sehr stark bedämpft und der Serienresonanzkreis ist das eigentlich frequenzbestimmende Glied. Es fließt ein hoher Strom durch den Serienresonanzkreis und die Blindleistung in ihm ist hoch. Dagegen ist die Spannung am Parallelresonanzkreis niedrig und die in ihm umgesetzte Blindleistung ist klein. In diesem Fall liefert die Stromrückkopplung den stabilsten Betrieb mit kleinstmöglicher Phasenverschiebung zwischen Strom und Spannung am Ausgang des Leistungsverstärkers.

Bei hochohmigen Lastimpedanzen wird dagegen Spannungsrückkopplung gewählt. Wegen der hochohmigen Lastimpedanz ist der Parallelresonanzkreis nur schwach bedämpft und stellt jetzt das eigentliche frequenzbestimmende Glied dar. Durch den Serienresonanzkreis fließt nur ein kleiner Strom und die Blindleistung in ihm ist klein. Dagegen ist die Spannung am Parallelresonanzkreis hoch und die in ihm umgesetzte Blindleistung ist ebenfalls groß. In diesem Fall liefert die Spannungsrückkopplung den stabilsten Betrieb. Geringfügige Phasenverschiebungen zwischen Strom und Spannung am Ausgang des Leistungsverstärkers spielen keine sehr große Rolle, weil der Strom wegen der hochohmigen Last insgesamt klein ist.

Die Umschaltung auf Spannungsrückkopplung bei hochohmigen Lasten hat aber noch einen weiteren Vorteil, der in der Mehrdeutigkeit der Resonanz der Eingangsimpedanz des Ausgangsfilters bei hochohmigen Lastimpedanzen begründet ist. Dies wird später noch ausführlicher beschrieben.

Der Vorteil der Rückkopplung in Verbindung mit der Umschaltung zwischen Strom- und Spannungsrückkopplung gegenüber dem Stand der Technik liegt darin, daß der Hochfrequenz-Leistungsgenerator auch bei stark schwankenden Lastimpedanzen immer bei der aktuellen Mittenfrequenz des Ausgangsfilters inklusive Lastimpedanz arbeitet. Dies äußert sich in einem besonders stabilen Betrieb mit kleinen Verlustleistungen in den Verstärkerelementen des Leistungsverstärkers, gleichbleibend hohem Wirkungsgrad und gleichbleibend hoher verfügbarer Leistung. Der stabile Betrieb erstreckt sich gleichzeitig bis zum Last-Kurzschluß und Last-Leerlauf.

Als Kriterium für die Umschaltung zwischen Strom- und Spannungsrückkopplung wird nach der Erfindung der Betrag der angeschlossenen Lastimpedanz verwendet. Ein charakteristischer Wert $R_c$ für die Lastimpedanz, bei dem die Umschaltung zweckmäßigerweise erfolgen soll, kann für jeden nach der Erfindung aufgebauten Hochfrequenz-Leistungsgenerator z.B. experimentell bestimmt werden. Dabei können getrennt die Bereiche der Lastimpedanz ermittelt werden, in denen jeweils Stormrückkopplung oder Spannungsrückkopplung den stabilsten Betrieb ergeben. Als chrakteristische Impedanz kann dann ein zwischen den Stabilitätsgrenzen liegender Wert genommen werden.

Die Erfinder haben herausgefunden, daß Stormrückkopplung gewählt werden muß, wenn die Blindleistung im Serienresonanzkreis wesentlich größer ist als die Blindleistung im Parallelresonanzkreis. Umgekehrt muß Spannungsrückkopplung gewählt werden, wenn die Blindleistung im Parallelresonanzkreis wesentlich größer ist als im Serienresonanzkreis. Die Verteilung der Blindleistung auf die beiden Resonanzkreise hängt aber vom aktuellen Wert der Lastimpedanz ab. Als zweckmäßige Umschaltgrenze hat sich dabei die Lastimpedanz herausgestellt, bei der die Blindleistungen in beiden Schwingkreisen gerade gleich sind.

In einer vorteilhaften Ausgestaltung der Erfindung wird der charakteristische Wert der Lastimpedanz, bei dessen Unter- oder Überschreitung auf Strom- oder Spannungsrückkopplung umgeschaltet wird, daher so gewählt, daß er ungefähr der Gleichung

$$R_c = \sqrt{L_s/C_p}$$

entspricht, wenn $L_s$ die Induktivität des Serienresonanzkreises und $C_p$ die Kapazität des Parallelresonanzkreises ist. Bei dieser charakteristischen Impedanz sind die Blindleistungen in beiden Schwingkreisen gerade gleich.

In vielen Anwendungsfällen stimmt das mittlere Impedanzniveau der Last nicht mit den Betriebsdaten der Verstärkerelemente im Leistungsverstärker des Hochfrequenz-Leistungsgenerators überein. In diesen Fällen kann die Spule des Parallelresonanzkreises in bekannter Weise als Übertrager ausgebildet sein. Mit einem solchen Übertrager kann z.B. eine im Mittel sehr hochohmige Last an Verstärkerelemente mit hohen zulässigen Spitzenströmen aber kleiner Spannungsfestigkeit angepaßt werden. In einer weiteren Ausgestaltung der Erfindung ist daher die Induktivität des Parallelresonanzkreises als Übertrager ausgebildet, wobei die Kapazität des Parallelkreises der Primärseite, d.h. der dem Leistungsverstärker zugewandten Seite dieses Übertragers parallel geschaltet ist. Damit die Rückkopplung erfindungsgemäß wieder über den Zweig mit der größeren Blindleistung erfolgt, muß dabei die Umschaltung zwischen Spannungs- oder Stromrückkopplung bei einem charackteristischen Wert der Lastimpedanz von ungefähr

$$R_c = \ddot{u}^2 * \sqrt{L_s/C_p}$$

erfolgen, wenn ü das Spannungs-Übersetzungsverhältnis des Übertragers ist.

In manchen Fällen kann es zusätzlich erwünscht sein, daß die Kapazität des Parallelresonanzkreises parallel zur Sekundärwicklung des Übertragers liegt. Dies kann z.B. der Fall sein, wenn die Ausgangsimpedanz des Hochfrequenz-Leistungsgenerators bei hohen Frequenzen asymptotisch nach Null gehen soll, was bei der zuvor beschriebenen Anordnung wegen der unvermeidlichen Streuinduktivität des Übertragers nicht gegeben ist. In einer weiteren Ausgestaltung der Erfindung wird daher die Induktivität des Parallelresonanzkreises als Übertrager ausgebildet, und die Kapazität des Parallelkreises der Sekundärseite dieses Übertragers parallel geschaltet. In diesem Fall erfolgt die Umschaltung der Rückkopplung auf Spannungs- oder Stromrückkopplung dann, wenn die Lastimpedanz einen charakteristischen Wert über- oder unterschreitet der ungefähr der Gleichung

$$R_c = \ddot{u} * \sqrt{L_s/C_p}$$

entspricht, wenn ü das Übersetzungsverhältnis des Übertragers ist.

Zur Einstellung der richtigen Rückkopplungsart muß die momentan wirksame Lastimpedanz wenigstens näherungsweise bekannt sein und mit dem charakteristischen Wert, bei dem eine Umschaltung erfolgen soll, verglichen werden. In einer Ausgestaltung der Erfindung ist dazu eine Meßanordnung zur Erfassung der Ausgangsspannung des Hochfrequenz-Leistungsgenerators oder einer dazu proportionalen Größe und eine Meßanordnung zur Erfassung des Ausgangsstomes des Hochfrequenz-Leistungsgenerators oder einer dazu proportionalen Größe vorhanden. Die Meßfaktoren der beiden Meßanordnungen sind dabei so voreingestellt, daß ihre Ausgangssignale ungefähr dann gleich sind, wenn die an den Hochfrequenz-Leistungsgenerator angeschlossene Impedanz den charakteristischen Wert hat. Außerdem ist eine Komparatorschaltung vorhanden, die die Ausgangssignale der beiden vorher beschriebenen Meßanordnungen miteinander vergleicht. Das Ausgangssignal dieser Komparatorschaltung springt dann um, wenn die Lastimpedanz entweder größer oder kleiner als der beschriebene charackteristische Wert wird und kann daher für die Umschaltung zwischen Spannungs- und Stromrückkopplung im Rückkopplungszweig des Hochfrequenz-Leistungsgenerators verwendet werden.

In vielen Fällen wird ein Hochfrequenz-Leistungsgenerator mit annähernd konstanter Ausgangsspannung betrieben. In solchen Fällen kann bei der Bestimmung der momentanen Lastimpedanz auf die Messung der Ausgangsspannung verzichtet werden.

In einer weiteren Ausgestaltung der Erfindung ist daher zur Bestimmung der Lastimpedanz nur eine Meßanordnung zur Erfassung des Ausgangsstromes des Hochfrequenz-Leistungsgenerators oder einer dazu proportionalen Größe vorhanden. Außerdem ist eine Komparatorschaltung vorhanden, die das Ausgangssignal dieser Meßanordnung mit einem Sollwert vergleicht, der so gewählt ist, daß er dem Ausgangssignal der Meßanordnung im Fall der charakteristischen Lastimpedanz gleich ist. Das Ausgangssignal der Komparatorschaltung springt dann wieder um, wenn die Lastimpedanz den charakteristischen Wert über- oder unterschreitet und wird daher zur Umschaltung zwischen Spannungs- und Stromrückkopplung im Rückkopplungszweig des Hochfrequenz-Leistungsgenerators verwendet.

Die Erfinder haben bei Messungen an mehreren nach der Erfindung aufgebauten Hohfrequenz-Leistungsgeneratoren festgestellt, daß die exakte Einhaltung des charakteristischen Impedanzwertes zur Umschaltung zwischen Strom- und Spannungsrückkopplung nicht notwendig ist, sondern gewisse Abweichungen zulässig sind. Um ein zu häufiges Umschalten bei einer Lastimpedanz zu vermeiden, deren Wert zufällig um den charakteristischen Wert herum schwankt, wird in einer weiteren Ausgestaltung der Erfindung zur Steuerung des Umschaltvorganges der Rückkopplung eine Komparatorschaltung verwendet, die eine Hysterese aufweist.

Hochfrequenz-Leistungsgeneratoren nach der Erfindung werden sehr häufig intermittierend betrieben. Ein Beispiel hierfür ist die Hochfrequenzchirurgie: Der Hochfrequenz-Chirurgiegenerator ist als Gerät zwar während der ganzen Operation eingeschaltet, Hochfrequenzleistung soll er aber immer nur kurzzeitig zum Schneiden oder Koagulieren abgeben. Das bedeutet, daß alle Hilfsspannungen des Gerätes zwar über einen großen Zeitraum zur Verfügung stehen, der eigentliche Hochfrequenz-Leistungsgenerator aber immer nur durch Betätigen eines Schalters vorübergehend eingeschaltet wird. Bei den folgenden Ausführungen ist deshalb zwischen zwei Arten von "Einschalten" zu unterscheiden. Zunächst muß das gesamte Gerät mit allen Hilfs-

EP 0 329 988 B1

spannungen und ev. vorhandenen peripheren Funktionen in Betrieb genommen werden. Der in dem Gerät enthaltene eigentliche Hochfrequenz-Leistungsgenerator wird in der Regel erst danach und nicht immer durchgehend eingeschaltet. Die weiteren Erklärungen über die Anschwinghilfe beziehen sich immer auf das Einschalten des Hochfrequenz-Leistungsgenerators, z.B. auch nach einer Arbeitspause, während der das gesamte Gerät zwar eingeschaltet blieb, aber keine Hochfrequenzleistung abgegeben wurde.

Bei jedem Einschalten des Hochfrequenz-Leistungsgenerators muß ein Anschwingvorgang ausgelöst werden. Der Hilfsoszillator, der als Anschwinghilfe dient, muß den Leistungsverstärker so ansteuern, daß die Rückkopplungsschaltung dem Ausgangskreis genügend große Ströme oder Spannungen auf der Betriebsfrequenz entnehmen kann, um die Selbsterregung aufrecht zu erhalten. Im einfachsten Fall ist der Hilfsoszillator nach der Erfindung daher so aufgebaut, daß er bei jedem Einschalten des Hochfrequenz-Leistungsgenerators einen einzigen Impuls an den Eingang des Leistungsverstärkers abgibt. Ein solcher Einzelimpuls regt das aus dem Serienresonanzkreis und dem Parallelresonanzkreis bestehende Ausgangsfilter zu Ausgleichvorgängen an, die bereits Ströme und Spannungen der Betriebsfrequenz enthalten, und in den meisten Fällen für das weitere Anschwingen über die Rückkopplungsschaltungen ausreichen.

Um das Anschwingen noch sicherer zu gestalten, kann der Hilfsoszillator nach einer weiteren Ausgestaltung der Erfindung bei jedem Einschalten des Hochfrequenz-Leistungsgenerators nacheinander solange Einzelimpulse an den Eingang des Leistungsverstärkers abgeben, bis der Hochfrequenz-Leistungsgenerator angeschwungen ist, d.h. die Ansteuerung des Leistungsverstärkers auf Rückkopplung umgeschaltet hat. In diesem Fall soll der zeitliche Abstand der Einzelimpulse größer sein als die Periodendauer der gewünschten mittleren Betriebsfrequenz, damit sich im Ausgangskreis nicht mehrere Ausgleichsvorgänge mit ungünstigen Phasenlagen addieren.

Ein besonderes sicheres Anschwingen erhält man mit einer weiteren Ausgestaltung der Erfindung, bei der der Hilfsoszillator eine kontinuierliche Wechselspannung abgibt, deren Frequenz der mittleren Betriebsfrequenz des Hochfrequenz-Leistungsgenerators entspricht. Dieser Hilfsoszillator kann vorteilhafterweise auch ein spannungsgesteuerter Oszillator (VCO) sein, dessen Ruhefrequenz der mittleren Betriebsfrequenz des Hochfrequenz-Leistungsgenerators entspricht. Bei jeder Inbetriebnahme des Hochfrequenz-Leistungsgenerators schwingt dieser VCO zunächst auf der mittleren Betriebsfrequenz. Es wird nun vorgeschlagen, eine Phasenregelung vorzusehen, die immer dann, wenn der eigentliche Hochfrequenz-Leistungsgenerator schwingt, d.h. mit Spannungs- oder Stromrückkopplung arbeitet, die Frequenz des Hilfsoszillators mit der momentanen Arbeitsfrequenz des Hochfrequenz-Leistungsgenerators synchronisiert. Weiterhin wird vorgeschlagen, den Hilfsoszillator in den Arbeitspausen des Hochfrequenz-Leistungsgenerators auf der zuletzt eingestellten Frequenz weiterschwingen zu lassen. Dies kann z.B. mit einer Sample-and-hold Schaltung zwischen der Phasenregelschaltung und dem VCO realisiert werden. Bei einer erneuten Aktivierung des Hochfrequenz-Leistungsgenerators gibt dann der Hilfsoszillator die letzte aktuelle Frequenz des Hochfrequenz-Leistungsgenerators als Anschwinghilfe an den Leistungsverstärker ab. Diese Frequenz hat den wahrscheinlichsten Wert für die Frequenz, mit der der Hochfrequenz-Leistungsgenerator nach dem Umschalten auf Selbsterregung weiterschwingen wird.

Zur weiteren Verdeutlichung der Erfindung sind noch Zeichnungen beigefügt. Es zeigen:

Fig. 1: Blockschaltbild eines Hochfrequenz-Leistungsgenerators mit Meßschaltungen zur Strom- und Spannungsmessung zur Bestimmung der Lastimpedanz.

Fig. 2: Ortskurven der vom Leistungsverstärker gesehenen Eingangsimpedanz des Ausgangsfilters für verschiedenen Werte des Lastwiderstandes $R_{Last}$.

Fig. 3: Blockschaltbild eines Hochfrequenz-Leistungsgenerators mit einer Meßschaltung zur Strommessung zur Abschätzung der Lastimpedanz.

Fig. 4: Blockschaltbild eines Hochfrequenz-Leistungsgenerators mit einer als Übertrager ausgebildeten Parallelkapazität $L_p$ zur Anpassung der Lastimpedanz.

Fig. 5: Blockschaltbild eines Hochfrequenz-Leistungsgenerators mit einem durch eine PLL-Schaltung synchronisierten Hilfsoszillator.

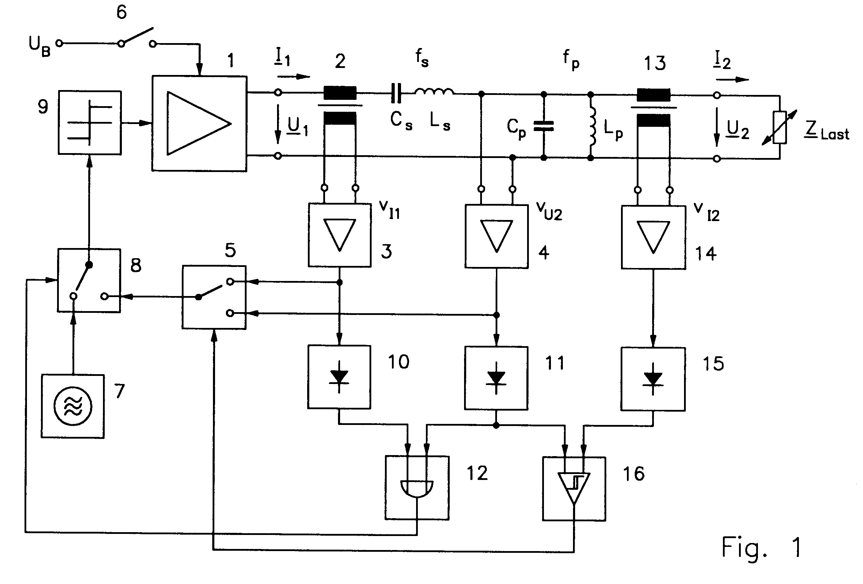

In Fig. 1 ist das Blockschaltbild eines Hochfrequenz-Leistungsgenerators mit Meßschaltungen zur Strom- und Spannungsmessung zur Bestimmung der Lastimpedanz dargestellt. Der Hochfrequenz-Leistungsgenerator enthält einen in Komplementär- oder Quasikomplementär-Schaltung aufgebauten Leistungsverstärker 1, an dessen Ausgang das aus einem Serienresonanzkreis ($L_s$ und $C_s$) und einem Parallelresonanzkreis ($C_p$ und $L_p$) gebildete Ausgangsfilter angeschlossen ist. Am Ausgang des Filters liegt die Lastimpedanz $Z_{Last}$. In Serie zum Serienresonanzkreis liegt ein Wandlerglied zur Erzeugung einer geeigneten Spannung für die Stromrückkopplung, das in diesem Beispiel aus einem Stromwandler 2 und einem Verstärker 3 besteht. In diesem Zweig sind aber auch andere Schaltungsvarianten möglich, wie z.B. ein kleiner Serienwiderstand an Stelle des Stromwandlers im Ausgangsstromkreis des Leistungsverstärkers. Parallel zum Parallelresonanzkreis liegt ein Wandlerglied zur Erzeugung einer geeigneten Spannung für die Spannungsrückkopplung, das in diesem

6

Beispiel aus dem Verstärker 4 besteht. Die Verstärker 3 und 4 weisen die im Blockschaltbild angegebenen Verstärkungen $v_{I1}$ und $v_{U2}$ auf, die so eingestellt sind, daß sich später eine passende Ansteuerspannung für den Leistungsverstärker ergibt. Wegen der hohen Ausgangsspannung des Leistungsverstärkers 1 wird die Verstärkung des im Spannungsrückkopplungszweiges liegenden Verstärkers 4 in der Regel $v_{U2} < 1$ sein.

Die Ausgangsspannungen der beiden Verstärker 3 und 4 werden dem elektronischen Umschalter 5 zugeführt, von dem sie entsprechend der momentanen Lastimpedanz ausgewählt werden.

Der Hochfrequenz-Leistungsgenerator wird in diesem Beispiel dadurch eingeschaltet, daß dem Leistungsverstärker 1 über den Schalter 6 die Betriebsspannung $U_s$ zugeführt wird. Es wird davon ausgegangen, daß das gesamte Hochfrequenzgerät mit den eventuell vorhandenen peripheren Einrichtungen und den Hilfsspannungen zu diesem Zeitpunkt bereits eingeschaltet war. Durch das Betätigen des Schalters 6 wird dann die Abgabe von Hochfrequenzleistung gestartet. In diesem Augenblick muß also das Anschwingen des Hochfrequenz-Leistungsgenerators initiiert werden. Dazu ist der Hilfsoszillator 7 über den elektronischen Schalter 8 und die Impulsformer- bzw. Vorverstärker-Stufe 9 an den Eingang des Leistungsverstärkers 1 geschaltet. Der Hilfsoszillator 7 ist in diesem Beispiel auf die mittlere Betriebsfrequenz, d.h. auf die Soll-Resonanzfrequenzen $f_s$ des Serienresonanzkreises und $f_p$ des Parallelresonanzkreises abgestimmt, die in der Regel als gleich angenommen werden können. Mit dieser Frequenz schwingt der Hochfrequenz-Leistungsgenerator an. Sobald jedoch eine der von den Verstärkern 3 und 4 aus dem Ausgangsstrom oder der Ausgangsspannung abgeleiteten Spannungen deutlich von Null verschieden ist, wird der elektronische Schalter 8 auf Selbsterregung, d.h. auf Rückkopplung umgeschaltet. Dies wird im vorliegenden Beispiel mithilfe der Gleichrichter 10 und 11 und der elektronischen ODER-Schaltung 12 bewerkstelligt.

Der Ausdruck "deutlich von Null verschieden" soll dabei so verstanden werden, daß die von den Verstärkern 3 und 4 aus dem Ausgangsstrom oder der Ausgangsspannung des Leistungsverstärkers 1 abgeleiteten Spannungen zur Ansteuerung des Leistungsverstärkers 1 ausreichen müssen. Wegen der hohen möglichen Schleifenverstärkungen sind dafür aber relativ kleine Spannungswerte ausreichend.

Die Schwellen der ODER-Schaltung 12 sind also so eingestellt, daß ihr Ausgangssignal umspringt, wenn die jeweilige Eingangsspannung eine für die Ansteuerung des Leistungsverstärkers 1 ausreichende Amplitude signalisiert.

Der elektronische Auswahlschalter 5 soll den Rückkopplungszweig erfindungsgemäß auf Stromrückkopplung schalten, wenn die Lastimpendanz den charakteristischen Wert unterschreitet, und auf Spannungsrückkopplung, wenn die Lastimpendanz den charakteristischen Wert überschreitet. Dazu ist in dem Beispiel der Fig. 1 ein weiterer Zweig aus einem Stromwandler 13, einem Verstärker 14, einem Gleichrichter 15 und einem Komparator 16 vorgesehen. Mit dem Stromwandler 13 wird ein dem Laststrom $I_2$ proportionales Signal abgegriffen, das mit dem Verstärker 14 in der Amplitude angepaßt und im Gleichrichter 15 gleichgerichtet wird. Danach wird es vom Komparator 16 mit dem Ausgangssignal des Gleichrichters 11 verglichen. Die Verstärkungen $v_{U2}$ des Verstärkers 4 und $v_{I2}$ des Verstärkers 14 sind dabei so eingestellt, daß das Ausgangssignal des Komparators 16 dann umspringt, wenn die Lastimpedanz den charakteristischen Wert durchläuft. Um dauerndes Umspringen des Komparators 16 zu vermeiden, wenn sich die Lastimpedanz längere Zeit genau auf dem Wert der charakteristischen Impedanz befindet, ist der Komparator 16 hier mit einer Hysterese versehen.

Bei Hochfrequenz-Leistungsgeneratoren nach der Erfindung arbeitet der Leistungsverstärker 1 im Schaltbetrieb. Da die Verstärkerelemente des Leistungsverstärkers 1 bei diesem Betrieb abwechselnd extrem hochohmig und extrem niederohmig sind, hat die Ausgangsspannung $U_1$ eine vernachlässigbar kleine Phasenverschiebung gegenüber der Steuerspannung des Leistungsverstärkers 1. Bei Stromrückkopplung wird die Steuerspannung aus dem Ausgangsstrom $I_1$ des Leistungsverstärkers 1 gewonnen. Achtet man darauf, daß die Phasenverschiebung im Strom-Rückkopplungszweig sehr gering ist, so hat man im Fall der Stromrückkopplung extrem geringe Phasenverschiebung zwischen Ausgangsstrom $I_1$ und Ausgangsspannung $U_1$. Die Frequenz stellt sich dabei automatisch so ein, daß diese Bedingung erfüllt ist. Es handelt sich hierbei vornehmlich um die aktuelle Resonanzfrequenz des Serienresonanzkreises. Veränderungen der Bauelemente $L_p$ und $C_p$ sowie Verstimmungen durch die Blindelemente der Lastimpedanz und Verstimmungen des Parallelresonanzkreises werden dabei automatisch berücksichtigt. Die Stromrückkopplung ergibt also geringstmögliche Verluste in den Verstärkerelementen des Leistungsverstärkers 1 und damit höchstmöglichen Wirkungsgrad, kleinste Überschwinger und damit sichersten Betrieb. Für die gewünschten Wirkungen der Hochfrequenzleistung spielen die dabei auftretenden geringen Frequenzverschiebungen i.a. keine Rolle, wie bereits früher beschrieben wurde.

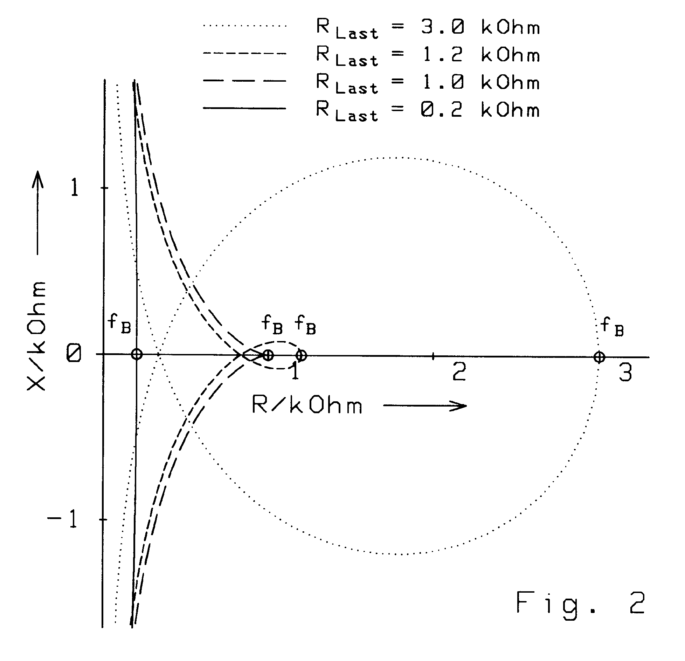

Trotzdem ist es vorteilhaft, auf Spannungsrückkopplung umzuschalten, wenn die Lastimpedanz die charakteristische Impedanz $R_c$ überschreitet. Dies soll mithilfe der Fig. 2 näher erläutert werden. Fig. 2 zeigt die Ortskurven der vom Leistungsverstärker 1 gesehenen Eingangsimpedanz des Ausgangsfilters für vier verschiedene Werte der Lastimpedanz. Der Einfachheit halber sind hier für die Lastimpedanz nur reelle Werte $R_{Last}$ angenommen. Das Beispiel ist für einen Fall gezeichnet, bei dem

$$\sqrt{L_s/C_p} \ = \ 1\text{kOhm}$$

gilt. Da die Resonanzfrequenzen $f_s$ des Serienresonanzkreises und $f_p$ des Parallelresonanzkreises nominell gleich sind, gilt

$$L_s * C_s \ = \ L_p * C_p$$

und damit auch

$$\sqrt{L_p/C_s} \ = \ 1\text{kOhm}.$$

Die charakteristische Impedanz $R_c$ wäre in diesem Beispiel also 1kOhm. Die vier Ortskurven in Fig. 2 sind für die Lastimpedanzen 0.2kOhm, 1 kOhm, 1.2kOhm und 3kOhm gezeichnet. Jede Ortskurve hat bei der Resonanzfrequenz des Serienresonanzkreises und des Parallelresonanzkreises einen Schnittpunkt mit der reellen Achse. Diese Frequenz ist in Fig. 2 jeweils als die gewünschte Betriebsfrequenz $f_B$ bezeichnet. Wenn die Lastimpedanz den Wert der charakteristischen Impedanz allerdings übersteigt, so bildet die Ortskurve der Eingangsimpedanz eine Schleife mit zwei weiteren Schnittpunkten mit der reellen Achse. Bei Stromrückkopplung würde der Hochfrequenz-Leistungsgenerator nun nicht mehr die gewünschte Betriebsfrequenz $f_B$, sondern eine der beiden anderen Frequenzen mit reeller Eingangsimpedanz einstellen. Bei dieser Frequenz fließen hohe Blindströme durch die Verstärkerelemente des Leistungsverstärkers, die verfügbare Leistung und der Wirkungsgrad nehmen rapide ab. Dafür steigt die Verlustleistung in den Verstärkerelementen des Leistungsverstärkers und die Betriebssicherheit ist gefährdet. Bei geringfügigen Überschreitungen der charakteristischen Impedanz ist dieser Effekt noch nicht sehr ausgeprägt, wie die Ortskurve für $R_{Last}$ = 1.2kOhm zeigt. Deshalb sind gewisse Toleranzen für die Umschaltschwelle zugelassen.

Bei hochohmigen Lastimpedanzen, verglichen mit der charakteristischen Impedanz, bringt eine erfindungsgemäße Umschaltung der Rückkopplung auf Spannungs-Rückkopplung den Hochfrequenz-Leistungsgenerator wieder auf die gewünschte Betriebsfrequenz $f_B$ zurück. Dies bringt erhebliche Vorteile hinsichtlich der Verlustleistung, des Wirkungsgrades, der verfügbaren Leistung und der Betriebssicherheit.

Bei einem niederohmigen Leistungsverstärker ist Spannungsrückkopplung grundsätzlich problematisch. Aus diesem Grund wird Mit der Erfindung vorgeschlagen, die Rückkopplungsspannung aus der Spannung am Parallelresonanzkreis, also hinter den Serienresonanzkreis zu gewinnen. In allen praktischen Fällen übernimmt dann weiterhin der Serienresonanzkreis die Frequenzführung, d.h. nach der Umschaltung zwischen Strom- und Spannungsrückkopplung schwingt der Hochfreqeunz-Leistungsgenerator praktisch mit der gleichen Frequenz weiter.

Es ist weiterhin einleuchtend, daß Fehlabgleiche der Resonanzkreise sowie Änderungen der Bauelementewerte bei Alterung durch die Rückkopplung ausgeglichen werden.

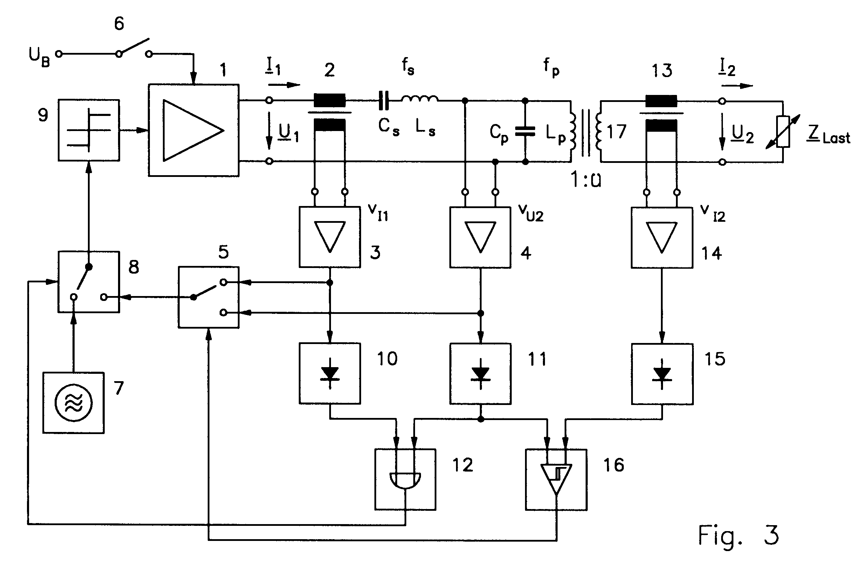

In Fig. 3 ist ein Hochfrequenz-Leistungsgenerator gezeigt, bei dem die Induktivität $L_p$ des Parallelresonanzkreises durch einen Übertrager mit dem Spannungsübersetzungsverhältnis 1:ü ersetzt ist. In diesem Beispiel ist die Schwingkreiskapazität Cp der Primärseite des Übertragers parallel geschaltet. In diesem Fall muß bei der Bestimmung der charakteristischen Impedanz $R_c$ das Impedanztransformationsverhältnis $ü^2$ des Übertragers berücksichtigt werden. Die Kapazität $C_p$ kann auch der Sekundärseite des Übertragers parallel geschaltet werden. In diesem Fall muß berücksichtigt werden, daß auch $C_p$ mit $1/ü^2$ in den Primärkreis transformiert erscheint, weshalb die charakteristische Impedanz $R_c$ entsprechend der früher beschriebenen Formel zu berechnen ist.

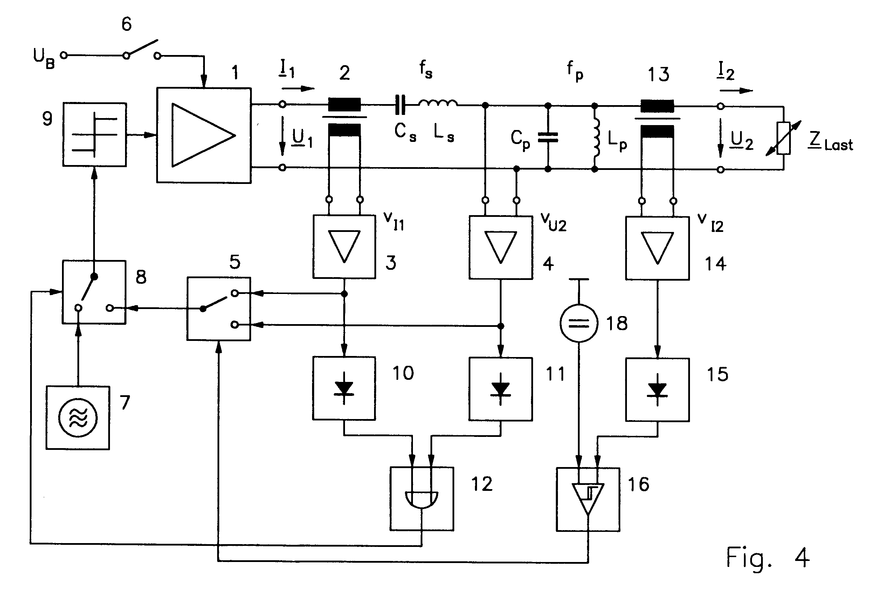

Das Beispiel eines Hochfrequenz-Leistungsgenerators, bei dem die Lastimpedanz zur Bestimmung des Umschaltkriteriums zwischen Strom- und Spannungsrückkopplung nur geschätzt wird, ist in Fig. 4 gezeigt. Diese Schaltung eignet sich für solche Fälle, in denen die Ausgangsspannung des Hochfrequenz-Leistungsgenerators keinen sehr großen Schwankungen unterworfen ist. In diesem Fall genügt es, nur den Laststrom $I_2$ zu messen und mit einem Sollwert zu vergleichen. In Fig. 4 wird dies mithilfe des Sollwertgebers 18 gemacht, der so eingestellt ist, daß seine Spannung ungefähr so groß ist wie die Ausgangsspannung des Gleichrichters 15 in einem typischen Betriebszustand, wenn die Lastimpedanz den Wert der charakteristischen Impedanz hat.

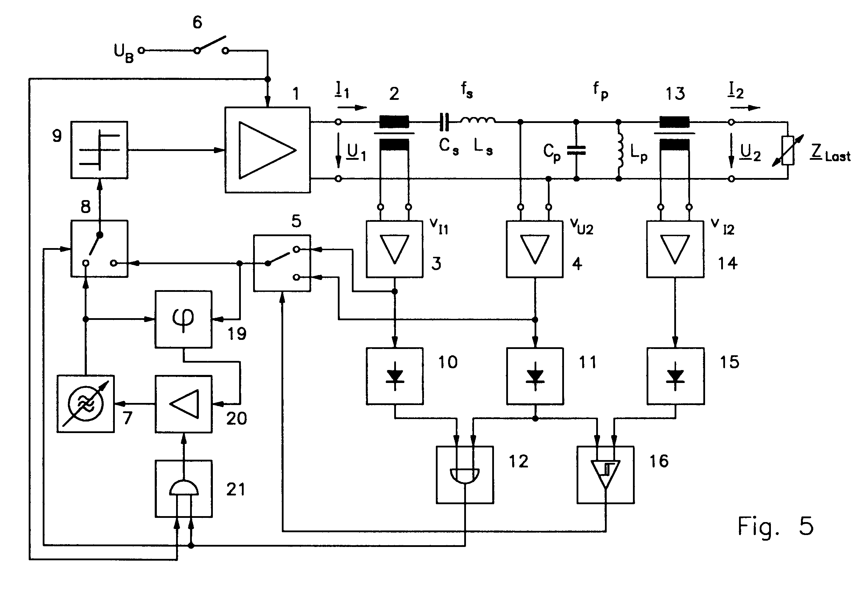

Fig. 5 zeigt einen Hochfrequenz-Leistungsgenerator, bei dem der Hilfsoszillator 7 als spannungsgeregelter Oszillator (VCO) aufgebaut ist. Die Ruhefrequenz dieses Hilfsoszillators entspricht der gewünschten Betriebsfrequenz. Mit dieser Frequenz gibt der Hilfsoszillator 7 dem Leistungsverstärker 1 bei der ersten Aktivierung Anschwinghilfe. Die Ausgangsspannung des Hilfsoszillators 7 wird mithilfe des Phasenmessers 19 mit der Schwingfrequenz des Hochfrequenz-Leistungsgenerators verglichen. Das Ergebnis dieser Phasenmessung, das nur sinnvoll ist, solange der Hochfrequenz-Leistungsgenerator im Rückkopplungsmode schwingt, wird an den Eingang des Sample-and-hold Verstärkers 20 gegeben. Sobald der Hochfrequenz-Leistungsgenerator angeschwungen ist, d.h. im Rückkopplungsmode arbeitet, wird der Sample-and-hold Verstärker 20 auf den Hilfsoszillator 7 durchgeschaltet. Dazu wird das Ausgangssignal der ODER-Schaltung 12, das auch die Umschaltung von Fremderregung auf Rückkopplung bewirkt, mit dem Aktivierungssignal des Schalters 6 in der UND-Schaltung 21 verknüpft und auf den Steuereingang des Sample-and-hold Verstärkers 20 gegeben.

Das Durchschalten des Sample-and-hold Verstärkers 20 schließt die Phasenregelschleife und synchronisiert den Hilfsoszillator 7 auf die momentane Selbsterregungsfrequenz des Hochfrequenz-Leistungsgenerators. Sobald der Hochfrequenz-Leistungsgenerator deaktiviert wird, wird der Sample-and-hold Verstärker 20 von der UND-Schaltung 21 abgeschaltet und der Hilfsoszillator 7 schwingt auf der letzten aktuellen Frequenz des Hochfrequenz-Leistungsgenerators weiter. Mit dieser Frequenz gibt er bei der nächsten Aktivierung Anschwinghilfe. Diese Frequenz besitzt in der Regel den wahrscheinlichsten Wert für die Frequenz, mit der der Hochfrequenz-Leistungsgenerator anschwingen wird.

**Patentansprüche**

1. Hochfrequenz-Leistungsgenerator mit einem als Komplementär- oder Quasikomplementär-Stufe aufgebauten, im Schaltbetrieb arbeitenden Leistungsverstärker, und einem Ausgangsfilter, welches einen ungefähr auf die mittlere Betriebsfrequenz abgestimmten in Serie geschalteten Serienresonanzkreis und einen ungefähr auf die mittlere Betriebsfrequenz abgestimmten parallel geschalteten Parallelresonanzkreis enthält, wobei der Serienresonanzkreis vom Leistungsverstärker aus gesehen das erste Filterelement darstellt, dadurch gekennzeichnet, daß
   - die Ansteuerspannung des Leistungsverstärkers (1) im Moment des Anschwingens von einem Hilfsoszillator (7) geliefert wird,
   - die Ansteuerung des Leistungsverstärkers (1) nach dem Anschwingen, d.h. wenn im Ausgangskreis des Leistungsverstärkers (1) entweder ein von Null deutlich unterschiedlicher Strom fließt oder eine von Null deutlich unterschiedliche Spannung herrscht, auf Selbsterregung, d.h. Rückkopplung aus dem Ausgangskreis des Leistungsverstärkers (1) umgeschaltet wird, wobei dann die Ansteuerspannung des Leistungsverstärkers
     - über ein Wandlerglied (2 und 3) und Impulsformerstufen (9) aus dem den Serienresonanzkreis ($L_s$ und $C_s$) durchfließenden Strom gewonnen wird, wodurch Stromrückkopplung entsteht, wenn der Betrag der an den Hochfrequenz-Leistungsgenerator angeschlossenen Lastimpedanz ($Z_{Last}$) einen charakteristischen, voreingestellten Wert ($R_c$) unterschreitet
     - über ein Wandlerglied (4) und Impulsformerstufen (9) aus der am Parallelresonanzkreis ($L_p$ und $C_p$) anliegenden Spannung gewonnen wird, wodurch Spannungsrückkopplung entsteht, wenn der Betrag der an den Hochfrequenz-Leistungsgenerator angeschlossenen Lastimpedanz ($Z_{Last}$) einen charakteristischen, voreingestellten Wert ($R_c$) überschreitet
   wobei ein elektronischer Schalter (5) für die Umschaltung zwischen diesen beiden Möglichkeiten der Rückkopplung vorgesehen ist, der bei schwankenden Lastimpedanzen auch während des Betriebes die beschriebene Umschaltung zwischen Strom- und Spannungsrückkopplung vornimmt, wenn der Betrag der Lastimpedanz den charakteristischen, vor eingestellten Wert ($R_c$) über- oder unterschreitet.

2. Hochfrequenz-Leistungsgenerator nach Anspruch 1, dadurch gekennzeichnet, daß der charakteristische Wert ($R_c$) der Lastimpedanz ($Z_{Last}$), bei dessen Unter- oder Überschreitung auf Strom- oder Spannungsrückkopplung umgeschaltet wird, ungefähr der Gleichung

$$R_c = \sqrt{L_s/C_p}$$

entspricht, wenn $L_s$ die Induktivität des Serienresonanzkreises und $C_p$ die Kapazität des Parallelresonanzkreises ist.

3. Hochfrequenz-Leistungsgenerator nach Anspruch 1, dadurch gekennzeichnet, daß die Induktivität ($L_p$) des Parallelresonanzkreises als Übertrager (13) zur Transformation der an den Hochfrequenz-Leistungsgenerator angeschlossenen Lastimpedanz ($Z_{Last}$) nach an sich bekannten Regeln ausgebildet ist, die Kapazität ($C_p$) des Parallelkreises der Primärseite, d.h. der dem Leistungsverstärker (1) zugewandten Seite dieses Übertragers (13) parallel geschaltet ist und die Umschaltung der Rückkopplung auf Spannungs- oder Stromrückkopplung erfolgt, wenn die Lastimpendanz ($Z_{Last}$) einen charakteristischen Wert ($R_c$) über- oder unterschreitet der ungefähr der Gleichung

$$R_c = ü^2 * \sqrt{L_s/C_p}$$

entspricht, wenn ü das Übersetzungsverhältnis des Übertragers (13) ist.

4. Hochfrequenz-Leistungsgenerator nach Anspruch 1, dadurch gekennzeichnet, daß die Induktivität ($L_p$) des Parallelresonanzkreises als Übertrager (13) zur Transformation der an den Hochfrequenz-Leistungsgenerator angeschlossen Lastimpedanz ($Z_{Last}$) nach an sich bekannten Regeln ausgebildet ist, die Kapazität des Parallelkreises der Sekundärseite, d.h. der dem Leistungsverstärker abgewandten Seite dieses Übertragers (13) parallel geschaltet ist und die Umschaltung der Rückkopplung auf Spannungs- oder Stromrückkopplung erfolgt, wenn die Lastimpedanz ($Z_{Last}$) einen charakteristischen Wert ($R_c$) über- oder unterschreitet der ungefähr der Gleichung

$$R_c = ü * \sqrt{L_s/C_p}$$

entspricht, wenn ü das Übersetzungsverhältnis des Übertragers (13) ist.

5. Hochfrequenz-Leistungsgenerator nach den Ansprüchen 1 bis 4, dadurch gekennzeichnet, daß
   - eine Meßanordnung (4 und 11) zur Erfassung der Ausgangsspannung ($U_2$) des Hochfrequenz-Leistungsgenerators oder einer dazu proportionalen Größe vorhanden ist,
   - eine Meßanordnung (14 und 15) zur Erfassung des Ausgangsstromes ($I_2$) des Hochfrequenz-Leistungsgenerators oder einer dazu proportionalen Größe vorhanden ist,
   - die Meßfaktoren ($v_{U2}$ und $v_{I2}$) der beiden Meßanordnungen (4, 11, 14 und 15) so voreingestellt sind, daß ihre Ausgangssignale ungefähr dann gleich sind, wenn die an den Hochfrequenz-Leistungsgenerator angeschlossene Impedanz ($Z_{Last}$) den charakteristischen Wert ($R_c$) hat und
   - eine Komparatorschaltung (16) vorhanden ist, die die Ausgangssignale der beiden vorher beschriebenen Meßanordnungen (4, 11, 14, und 15) miteinander vergleicht, und das Ausgangssignal der Komparatorschaltung (16) die Umschaltung zwischen Spannungs- und Stormrückkopplung im Rückkopplungszweig des Hochfrequenz-Leistungsgenerators steuert.

6. Hochfrequenz-Leistungsgenerator nach den Ansprüchen 1 bis 4, dadurch gekennzeichnet, daß eine Meßanordnung (14 und 15) zur Erfassung des Ausgangsstromes ($I_2$) des Hochfrequenz-Leistungsgenerators oder einer dazu proportionalen Größe vorhanden ist, und eine Komparatorschaltung (16) vorhanden ist, die das Ausgangssignal dieser Meßanordnung (14 und 15) mit einem Sollwert (18) vergleicht, und das Ausgangssignal der Komparatorschaltung (16) die Umschaltung zwischen Spannungs- und Stromrückkopplung im Rückkopplungszweig des Hochfrequenz-Leistungsgenerators steuert, wobei der Sollwert (18) so eingestellt ist, daß die Umschaltung zwischen Spannungs- und Stromrückkopplung ungefähr beim charakteristischen Wert ($R_c$) der Lastimpedanz ($Z_{Last}$) erfolgt.

7. Hochfrequenz-Leistungsgenerator nach den Ansprüchen 5 und 6, dadurch gekennzeichnet, daß die Komparatorschaltung (16) eine Hysterese aufweist.

8. Hochfrequenz-Leistungsgenerator nach den Ansprüchen 1 bis 7, dadurch gekennzeichnet, daß der Hilfsoszillator (7) bei jedem Einschalten des Hochfrequenz-Leistungsgenerators einen einzigen Impuls an den Eingang des Leistungsverstärkers (1) abgibt.

9. Hochfrequenz-Leistungsgenerator nach den Ansprüchen 1 bis 7, dadurch gekennzeichnet, daß der Hilfsoszillator (7) bei jedem Einschalten des Hochfrequenz-Leistungsgenerators nacheinander soviel Einzelimpulse an den Eingang des Leistungsverstärkers (1) abgibt, bis der Hochfrequenz-Leistungsgenerator angeschwungen ist, d.h. die Ansteuerung des Leistungsverstärkers auf Rückkopplung umgeschaltet hat, wobei der zeitliche Abstand der Einzellimpulse größer ist als die Periodendauer der gewünschten mittleren Betriebsfrequenz.

10. Hochfrequenz-Leistungsgenerator nach den Ansprüchen 1 bis 7, dadurch gekennzeichnet, daß der Hilfsoszillator (7) eine kontinuierliche Wechselspannung abgibt, deren Frequenz der mittleren Betriebsfrequenz des Hochfrequenz-Leistungsgenerators entspricht.

11. Hochfrequenz-Leistungsgenerator nach den Ansprüchen 1 bis 7, dadurch gekennzeichnet, daß der Hilfsoszillator (7) ein spannungsgesteuerter Oszillator ist, dessen Ruhefrequenz der mittleren Betriebsfrequenz des Hochfrequenz-Leistungsgenerators entspricht, und eine Phasenregelschaltung (19, 20 und 21) vorhanden ist, die immer dann, wenn der Hochfrequenz-Leistungsgenerator schwingt, d.h. mit Spannungs- oder Stromrückkopplung arbeitet, die Frequenz des Hilfsoszillators (7) mit der momentanen Arbeitsfrequenz des Hochfrequenz-Leistungsgenerators synchronisiert, und der Hilfsoszillator (7) in den Arbeitspausen des Hochfrequenz-Leistungsgenerators auf der zuletzt eingestellten Frequenz weiterschwingt und diese Frequenz beim erneuten Aktivieren des Hochfrequenz-Leistungsgenerators als Anschwinghilfe an den Leistungsverstärker (1) abgibt.

## Claims

1. High-frequency power generator with a power amplifier operating in the switched mode constructed as a complementary or semi-complementary stage, and an output filter which contains a series-connected series resonance circuit tuned approximately to the mean operating frequency and a parallel-connected parallel resonance circuit tuned approximately to the mean operating frequency, wherein the series resonance circuit represents the first filter element viewed from the power amplifier, characterised in that
   - the drive voltage of the power amplifier (1) at the moment of starting the oscillations is supplied by an auxiliary oscillator (7),
   - after starting the oscillations, i.e. when in the output circuit of the power amplifier (1) there flows a current which is clearly different from zero or the voltage is clearly different from zero, the drive of the power amplifier (1) is switched to self-excitation, i.e. feedback from the output circuit of the power amplifier (1), wherein the drive voltage of the power amplifier is then
   - obtained via a transformer element (2 and 3) and pulse shaping stages (9) from the current flowing through the series resonance circuit ($L_s$ and $C_s$) which results in current feedback when the value of the load impedance ($Z_{load}$) connected to the high-frequency power generator falls below a characteristic preadjusted value ($R_s$)
   - obtained via a transformer element (4) and pulse shaping stages (9) from the voltage applied to the parallel resonance circuit ($L_p$ and $C_p$), which results in voltage feedback when the value of the load impedance ($Z_{load}$) connected to the high-frequency power generator exceeds a characteristic, preadjusted value ($R_c$)
   - wherein an electronic switch (5) is provided for switching between these two feedback possibilities which during fluctuating load impedances carries out the said switching between current and voltage feedback also during the operation when the value of the load impedance exceeds or falls below the characteristic, preadjusted value ($R_c$).

2. High-frequency power generator according to claim 1, characterised in that the characteristic value ($R_c$) of the load impedance ($Z_{load}$) the excess or shortfall of which results in switching to current or voltage feedback, corresponds approximately to the equation

$$R_c = \sqrt{L_s/C_p}$$

when $L_s$ is the inductance of the series resonance circuit and $C_p$ is the capacitance of the parallel resonance circuit.

3. High-frequency power generator according to claim 1, characterised in that the inductance ($L_p$) of the parallel resonance circuit is designed according to rules known per se as transformer (13) for the transformation of the load impedance ($Z_{load}$) connected to the high-frequency power generator, the capacitance ($C_p$) of the parallel circuit is connected in parallel with the primary side, i.e. the side of this transformer (13) facing the power amplifier (1), and the feedback is switched to voltage or current feedback when the load impedance ($Z_{load}$) exceeds or falls below a characteristic value ($R_c$) which corresponds approximately to the equation

$$R_c = u^2 * \sqrt{L_s/C_p}$$

when u is the transformation ratio of the transformer (13).

4. High-frequency power generator according to claim 1, characterised in that the inductance ($L_p$) of the parallel resonance circuit is designed according to rules known per se as transformer (13) for the transformation of the load impedance ($Z_{load}$) connected to the high-frequency power generator, the capacitance of the parallel circuit is connected in parallel with the secondary side, i.e. the side of this transformer (13) facing away from the power amplifier, and the feedback is switched to voltage or current feedback when the load impedance ($Z_{load}$) exceeds or falls below a characteristic value ($R_c$) which corresponds approximately to the equation

$$R_c = u * \sqrt{L_s/C_p}$$

when u is the transformation ratio of the transformer (13).

5. High-frequency power generator according to the claims 1 to 4, characterised in that
   - a measuring device (4 and 11) is provided for detecting the output voltage ($U_2$) of the high-frequency power generator or a quantity proportional thereto,
   - a measuring device (14 and 15) is provided for detecting the output current ($I_2$) of the high-frequency power generator or a quantity proportional thereto,

- the measuring factors ($V_{u2}$ and $V_{l2}$) of the two measuring devices (4, 11, 14 and 15) are preadjusted in such a way that their output signals are approximately equal when the impedance ($Z_{load}$) connected to the high-frequency power generator has the characteristic value ($R_c$) and
- a comparator circuit (16) is provided which compares the output signals of the two previously described measuring devices (4, 11, 14 and 15) with each other and the-output signal of tile comparator circuit (16) controls the switching between voltage and current feedback in the feedback branch of the high-frequency power generator.

6. High-frequency power generator according to the claims I to 4, characterised in that
a measuring device (14 and 15) is provided for detecting the output current ($I_2$) of the high-frequency power generator or a quantity proportional thereto, and a comparator circuit (16) is provided which compares the output signal of this measuring device (14 and 15) with a desired value (18), and the output signal of the comparator circuit (16) controls the switching between voltage and current feedback in the feedback branch of the high-frequency power generator, wherein the switching between voltage and current feedback takes place approximately at the characteristic value (Rc) of the load impedance ($Z_{load}$).

7. High-frequency power generator according to the claims 5 and 6, characterised in that
the comparator circuit (16) has a hysteresis.

8. High-frequency power generator according to the claims 1 to 7, characterised in that
each time the high-frequency power generator is switched on, the auxilliary oscillator (7) supplies a single pulse to input of the power amplifier (1).

9. High-frequency power generator according to the claims 1 to 7, characterised in that
each time the high-frequency generator is switched on, the auxilliary oscillator (7) supplies successive individual pulses to the input of the power amplifier (1) until the high-frequency power generator starts to oscillate i.e. the drive of the power amplifier has switched to feedback, wherein the periodic interval of the individual pulses is greater than the duration of the periods of the desired mean operating frequency.

10. High-frequency power generator according to the claims 1 to 7, characterised in that the auxiliary oscillator (7) supplies a continuous alternating voltage whose frequency corresponds to the mean operating frequency of the high-frequency power generator.

11. High-frequency power generator according to the claims 1 to 7, characterised in that
the auxiliary oscillator (7) is a voltage-controlled oscillator whose rest frequency corresponds to 11-he mean operating frequency of the high-frequency power generator, and a phase control circuit (19, 20 and 21) is provided which synchronises the frequency of the auxiliary oscillator (7) with the instantaneous operating frequency of the high-frequency power generator whenever the high-frequency power generator oscillates, i.e. operates with voltage or current feedback, and during pauses in the operation of the high-frequency power generator the auxiliary oscillator (7) continues oscillating at the frequency last adjusted to and on the renewed activation of the high-frequency power generator supplies this frequency to the power amplifier (1) to aid the start of the oscillations.

## Revendications

1. Générateur de puissance à haute fréquence, avec un amplificateur de puissance constitué d'un étage complémentaire ou quasi complémentaire, travaillant en fonctionnement commuté, et avec un filtre de sortie, qui contient un circuit à résonance série, conçu à peu près pour la fréquence de fonctionnement moyenne et branché en série, et un circuit de résonance parallèle, conçu pour à peu près pour la fréquence de fonctionnement moyenne et branché en parallèle, le circuit à résonance série constituant depuis l'amplificateur de puissance le premier élément de filtrage, caractérisé en ce que
   - la tension de commande de l'amplificateur de puissance (1) est fournie au moment de la mise en oscillation d'un oscillateur auxiliaire 7,
   - la commande de l'amplificateur de puissance (1) est commutée, après mise en oscillation, c'est-à-dire lorsque dans le circuit de sortie de l'amplificateur de puissance (1) passe soit un courant de la valeur nettement différente de zéro, soit une tension nettement différente de zéro, pour passer à une auto-excitation, c'est-à-dire une contre-réaction partant du circuit sortie de l'amplificateur de

EP 0 329 988 B1

puissance (1), la tension de commande de l'amplificateur de puissance étant alors

- obtenue par un organe convertisseur (2 et 3) et des étages formateurs d'impulsions (9), à partir du courant passant dans le circuit à résonance série ($L_s$ et $C_s$), une contre-réaction en courant étant produite lorsque la valeur de l'impédance de charge ($Z_{charge}$) raccordée au générateur de puissance à haute fréquence descend au-dessous d'une valeur ($R_c$) préréglée, caractéristique,
- étant obtenue par un organe convertisseur (4) et des étages formateur d'impulsion (9) à partir de la tension appliquée sur le circuit à résonance parallèle ($L_p$ et $C_p$), faisant qu'est produite une contre réaction en tension, lorsque la valeur de l'impédance de charge ($Z_{charge}$) raccordée au générateur de puissance à haute fréquence, dépasse une valeur ($R_c$) préréglée caractéristique.

un interrupteur électronique (5) destiné à opérer à une commutation entre ces deux possibilités de contre-réaction étant prévu et effectuant, en cas de fluctuation des impédances de charge, également pendant le fonctionnement, la commutation décrite entre contre-réaction en intensité et contre-réaction en tension, lorsque la valeur de l'impédance de charge dépasse ou bien descend au-dessous de la valeur ($R_c$) préréglée caractéristique.

2. Générateur de puissance à haute fréquence selon la revendication 1, caractérisé en ce que la valeur caractéristique ($R_c$) de l'impédance de charge ($Z_{charge}$), lors du franchissement en descente ou en montée de laquelle est effectuée une commutation de contre-réaction en intensité ou en tension, correspond à peu près à l'égalité

$$R_c = \sqrt{L_s/C_p}$$

lorsque $L_s$ est l'inductance du circuit à résonance série et $C_p$ la capacité du circuit à résonance parallèle.

3. Générateur de puissance à haute fréquence selon la revendication 1, caractérisé en ce que l'inductance ($L_p$) du circuit à résonance parallèle est réalisée à titre d'organe de transmission (13), pour assurer la transformation de l'impédance de charge ($Z_{charge}$) raccordée au générateur de puissance à haute fréquence, d'après des règles connues en soi, la capacité ($C_p$) du circuit parallèle, du côté primaire, c'est-à-dire du côté tourné vers l'amplificateur de puissance (1) de cet organe transmetteur (13), étant branchée en parallèle et la commutation de la contre-réaction donnant le passage en contre-réaction de tension ou d'intensité s'effectuant lorsque l'impédance de charge ($Z_{charge}$) franchit en montée ou en descente une valeur caractéristique ($R_c$) correspondant à peu près à l'équation

$$R_c = ü^2 \pm \sqrt{L_s/C_p}$$

dans laquelle ü est le rapport de transformation de l'organe de transmission (13).

4. Générateur de puissance à haute fréquence selon la revendication 1, caractérisé en ce que l'inductance ($l_p$) du circuit à résonance parallèle est réalisée sous forme d'organe de transmission (13) pour assurer la transformation de l'impédance de charge ($Z_{charge}$) raccordée au générateur de puissance à haute fréquence, selon des règles connues en soi, la capacité du circuit parallèle du côté secondaire, c'est-à-dire du côté opposé à l'amplificateur de puissance de cet organe transmetteur (13), étant branché en parallèle et la commutation de passage de la contre-réaction la faisant passer à une contre-réaction en tension ou en intensité s'effectuant lorsque l'impédance de charge ($Z_{charge}$) franchit en montée ou en descente une valeur ($R_c$) caractéristique correspondant à peu près à l'équation

$$R_c = ü^2 \pm \sqrt{L_s/C_p}$$

dans laquelle u est le rapport de transformation de l'organe de transmission (13).

5. Générateur de puissance à haute fréquence selon les revendications 1 à 4, caractérisé en ce que
- un dispositif de mesure (4, 11) destiné à appréhender la tension de sortie ($U_2$) du générateur de puissance à haute fréquence ou d'une grandeur lui étant proportionnelle étant prévu,
- un dispositif de mesure (14 et 15) destiné à appréhender une intensité de sortie ($I_2$) du générateur de puissance à haute fréquence ou d'une grandeur lui étant parallèle étant prévu,
- les facteurs de mesure ($V_{U2}$ et $V_{I2}$) des deux dispositifs de mesure (4, 11, 14 et 15) étant préréglés de manière que leurs signaux de sortie soient à peu près égaux lorsque l'impédance ($Z_{charge}$) raccordée au générateur de puissance à haute fréquence présente la valeur ($R_c$) caractéristique, et
- un circuit comparateur (16) étant prévu, qui compare entre eux les signaux de sortie des deux dispositifs de mesure (4, 11, 14 et 15) décrits ci-dessus et le signal de sortie du circuit comparateur (16) commande la commutation entre contre-réaction en tension et en intensité dans la branche de contre-réaction du générateur de puissance à haute fréquence.

13

6. Générateur de puissance à haute fréquence selon les revendications 1 à 4, caractérisé en ce qu'un dispositif de mesure (14 et 15) destiné à appréhender le courant de sortie ($I_2$) du générateur de puissance à haute fréquence ou bien une grandeur lui étant proportionnelle est prévu, et un circuit comparateur (16) est prévu, qui compare le signal de sortie de ce dispositif de mesure (14 et 15) à une valeur de consigne (18) et le signal de sortie du circuit comparateur (16) commandant la commutation entre la contre-réaction en tension et en intensité dans la branche de contre-réaction du générateur de puissance à haute fréquence, la valeur de consigne (18) étant réglée à une valeur telle que la commutation entre contre-réaction en tension et en intensité s'effectue à peu près pour la valeur ($R_c$) caractéristique de l'impédance de charge ($Z_{charge}$).

7. Générateur de puissance à haute fréquence selon les revendications 5 et 6, caractérisé en ce que le circuit comparateur (16) présente une hystérésis.

8. Générateur de puissance à haute fréquence selon les revendications 1 à 7, caractérisé en ce que l'oscillateur auxiliaire (7) envoie à chaque mise en circuit du générateur de puissance à haute fréquence une impulsion unique à l'entrée de l'amplificateur de puissance (1).

9. Générateur de puissance à haute fréquence selon les revendications 1 à 7, caractérisé en ce que l'oscillateur auxiliaire (7) envoie à chaque mise en service du générateur de puissance à haute fréquence un nombre d'impulsion individuelle successive à l'entrée de l'amplificateur de puissance (1), tel que nécessaire jusqu'à ce que le générateur de puissance à haute fréquence soit entré en oscillation, c'est-à-dire que la commande de l'amplificateur de puissance soit commutée en contre réaction, l'intervalle temporel entre les impulsions individuelles étant supérieur à la durée de la période de la fréquence de fonctionnement moyenne souhaitée.

10. Générateur de puissance à haute fréquence selon les revendications 1 à 7, caractérisé en ce que l'oscillateur auxiliaire (7) envoie une tension alternative permanente, dont la fréquence correspondant à la fréquence de fonctionnement moyenne du générateur de puissance à haute fréquence.

11. Générateur de puissance à haute fréquence selon les revendications 1 à 7, caractérisé en ce que l'oscillateur auxiliaire (7) est un oscillateur commandé en tension, dont la fréquence de repos correspond à la fréquence de fonctionnement moyenne du générateur de puissance à haute fréquence, et un circuit de régulation de phase (19, 20 et 21) étant prévu, qui, lorsque le générateur de puissance à haute fréquence oscille, c'est-à-dire travaille avec une contre-réaction en tension ou en intensité, synchronise la fréquence de l'oscillateur auxiliaire (7) avec la fréquence de travail instantanée du générateur de puissance à haute fréquence et continue à faire osciller l'oscillateur auxiliaire (7) lors des pauses de travail du générateur de puissance à haute fréquence, à la dernière fréquence réglée, et envoie ces fréquences à l'amplificateur de puissance (1), à titre d'aide de mise en oscillation lors d'une nouvelle activation du générateur de puissance à haute fréquence.

Fig. 1

Fig. 2

Fig. 3

Fig. 4

Fig. 5